# EUROPÄISCHE PATENTSCHRIFT

(11) **EP 1 010 015 B1**
(45) Veröffentlichungstag und Bekanntmachung des Hinweises auf die Patenterteilung: **31.07.2002**
(21) Anmeldenummer: 98966962.7
(22) Anmeldetag: 20.08.1998
(51) Int. Cl.: G01R 21/06, G01R 21/133

(54) **MESSANORDNUNG ZUR LEISTUNGS- UND/ODER LEISTUNGSFAKTORMESSUNG AN MINDESTENS EINER MESSTELLE IN EINEM WECHSELSPANNUNGSNETZ**
MEASURING SYSTEM FOR MEASURING THE POWER AND/OR THE POWER FACTOR AT AT LEAST ONE MEASURING POINT IN AN ALTERNATING VOLTAGE NETWORK
SYSTEME DE MESURE POUR MESURER LA PUISSANCE ET/OU LE FACTEUR DE PUISSANCE EN AU MOINS UN POINT DE MESURE D'UN RESEAU DE TENSION ALTERNATIVE

(30) Priorität: 01.09.1997 DE 19738140
(43) Veröffentlichungstag der Anmeldung: 21.06.2000
(73) Patentinhaber: SIEMENS AKTIENGESELLSCHAFT, 80333 München (DE)
(72) Erfinder: Köck, Gerd, 70499 Stuttgart (DE)
(86) Internationale Anmeldenummer: DE9802429
(87) Internationale Veröffentlichungsnummer: WO9912047

(56) Entgegenhaltungen:
- EP-A- 0 853 364
- WO-A-94/03818

## Beschreibung

Die Erfindung betrifft eine Meßanordnung nach dem Oberbegriff des Anspruchs 1, wie sie auch aus der WO-A-94 038 18 bekannt ist.

Zur Leistungs- und/oder Leistungsfaktormessung an unterschiedlichen Meßstellen in Wechselspannungsnetzen, insbesondere an Einspeisungspunkten und Abzweigen, beispielsweise einer Schaltanlage, sind dort entsprechende Meßgeräte, z. B. Netzqualitätsmeßgeräte, angeordnet, die üblicherweise Spannungswandlereingänge und Stromwandlereingänge aufweisen. An den Meßstellen sind für die einzelnen Phasen Stromwandler vorhanden, die an den Stromwandlereingängen des dortigen Meßgeräts angeschlossen sind. Die Spannungswandlereingänge der an den verschiedenen Meßstellen angeordneten Meßgeräte sind über Leitungen mit Spannungswandlern verbunden, die an einer zentralen Spannungserfassungsstelle in dem Wechselspannungsnetz, z. B. den Sammelschienen in einer Schaltanlage, angeordnet sind. Die Übertragung der Spannungen von der Spannungserfassungsstelle zu den einzelnen Meßgeräten an den Meßstellen ist insbesondere bei großen Schaltanlagen durch Störungen in Form von Rauschen, Einkopplung von Fremdsignalen und Spannungsverlagerungen bei Erdströmen beeinflußt. Zudem ist der schaltungstechnische Aufwand durch die Spannungswandlereingänge an jedem Meßgerät und die Leitungen zur Spannungsübertragung von den Spannungswandlern an der Spannungserfassungsstelle zu den einzelnen Meßgeräten sehr hoch. Entsprechendes gilt auch, wenn statt dessen an jeder einzelnen Meßstelle Spannungswandler für jede Phase vorhanden sind.

Der Erfindung liegt die Aufgabe zugrunde, eine störungsfreie Zuführung der Spannung zu jedem Meßgerät sicher zu stellen und den schaltungstechnischen Aufwand zur Leistungs- und/oder Leistungsfaktormessung an mehreren Meßstellen in einem Wechselspannungsnetz zu verringern.

Gemäß der Erfindung wird die Aufgabe durch die in Anspruch 1 angegebene Meßanordnung gelöst.

Der wesentliche Vorteil der erfindungsgemäßen Meßanordnung besteht darin, daß bei den dort vorhandenen Meßgeräten im Unterschied zu den entsprechenden bisher bekannten Meßgeräten jeweils die Spannungswandlereingänge mit der nachgeordneten erforderlichen Elektronik und der dazugehörigen Verkabelung entfallen. Statt dessen werden die zur Leistungs- und/oder Leistungsfaktormessung erforderlichen Informationen über die Spannungen des Wechselspannungsnetzes von der Spannungserfassungsstelle aus digital an die einzelnen Meßgeräte übertragen. Die Informationsübertragung kann dabei über einen internen Bus, ein Lichtwellenleiternetz oder drahtlos erfolgen.

Die digital übertragenen vorgegebenen Informationen über die erfaßten Spannungen umfassen vorzugsweise die Spannungswerte und die Periodenzeit. Dabei muß die Erfassungszeit der Netzperiode sehr genau ermittelt werden, um die Leistungsund/oder Leistungsfaktormessung in den einzelnen Meßgeräten mit hoher Genauigkeit zu ermöglichen. Außerdem müssen die Meßgeräte sehr genau zeitsynchronisiert werden, um Phasenfehler zu vermeiden. Zur Kompensation von Phasenabweichungen zwischen den Spannungswandlern und den Stromwandlern an den unterschiedlichen Meßstellen wird in einem Kalibrierungsvorgang die Phasenabweichung für jedes Meßgerät ermittelt, wobei der Phasenwinkelfehler vorzugsweise in einen Speicher des Meßgerätes eingegeben wird; das Meßgerät kompensiert aufgrund des gespeicherten Phasenwinkelfehlers automatisch die Phasenwinkelabweichung. Zur Ermittlung des Phasenwinkelfehlers werden dem Meßgerät beispielsweise rechteckförmige Signale über die Stromwandlereingänge und die Datenübertagungseinrichtung zugeführt, wobei der Phasenwinkelfehler, bezogen auf die digital übertragenen Spannungsinformationen, über die Harmonischen bestimmt wird.

An der Spannungserfassungsstelle ist vorzugsweise ein weiteres Meßgerät mit Spannungswandlereingängen angeordnet, an denen die Spannungswandler angeschlossen sind, wobei das weitere Meßgerät zur Erzeugung der vorgegebenen Informationen über die erfaßten Spannungen ausgebildet ist. In der Meßanordnung kommen somit überall die gleichen Meßgeräte zum Einsatz, die sich von den bekannten Meßgeräten in vorteilhafter Weise dadurch unterscheiden, daß eines der Meßgeräte, nämlich das an der Spannungserkennungsstelle, keine Stromwandlereingänge und die übrigen Meßgeräte keine Spannungswandlereingänge aufweisen.

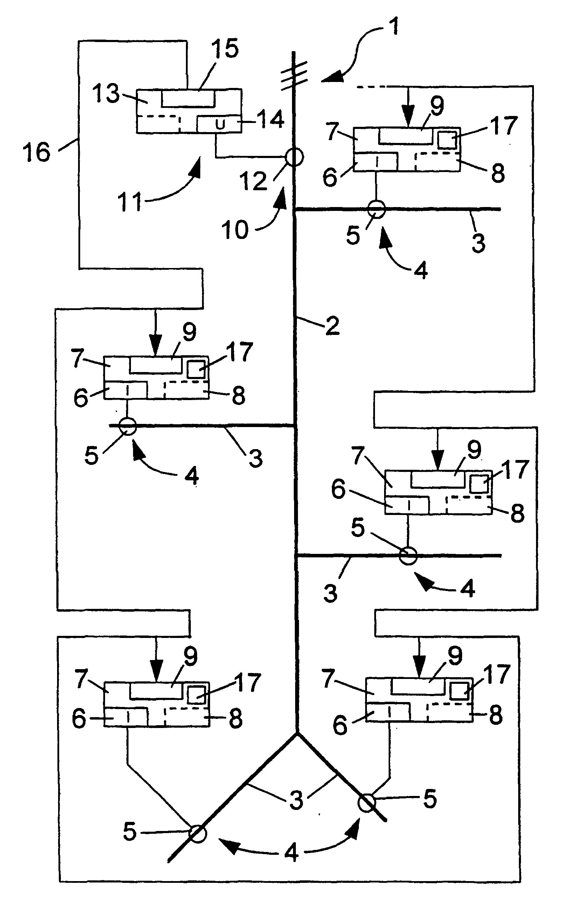

Im weiteren wird die Erfindung anhand eines in der Figur der Zeichnung dargestellten Beispiels der erfindungsgemäßen Meßanordnung erläutert.

Ein Wechselspannungsnetz 1, z. B. eine Schaltanlage, weist für jede Phase jeweils eine Sammelschiene 2 mit mehreren Abzweigen 3 auf, an denen die Leistung und/oder der Leistungsfaktor gemessen werden soll. Dazu sind an jedem Abzweig 3 an einer Meßstelle 4 Stromwandler 5 für die verschiedenen Phasen angeordnet, wobei die Stromwandler 5 an Stromwandlereingängen 6 eines im Bereich der jeweiligen Meßstelle 4 angeordneten Meßgerätes 7 zur Leistungs- und/oder Leistungsfaktormessung angeschlossen sind. Die mit 7 bezeichneten Meßgeräte entsprechen bisher bekannten Meßgeräten mit dem Unterschied, daß, wie hier gestrichelt dargestellt ist, Spannungswandlereingänge 8 mit der zugehörigen Elektronik fehlen und statt dessen eine Datenschnittstelle 9 zum Empfang digitaler Spannungsinformationen vorhanden ist.

An einer zentralen Spannungserfassungsstelle 10 des Wechselspannungsnetzes 1, hier an den Sammelschienen 2, ist eine Spannungswandlereinrichtung 11, bestehend aus Spannungswandlern 12 für die unterschiedlichen Phasen und einem weiteren Meßgerät 13, angeordnet. Das weitere Meßgerät 13 unterscheidet sich von den mit 7 bezeichneten Meßgeräten dadurch, daß die Stromwandlereingänge 6 fehlen und statt dessen Spannungswandlereingänge 14 vorhanden sind, an denen die Spannungswandler 12 angeschlossen sind. Die erfaßten Spannungen werden in dem Meßgerät 13 wie bei bisherigen Meßgeräten für eine Leistungs- und/oder Leistungsfaktormessung aufbereitet; im Unterschied zu den bekannten Meßgeräten werden vorgegebene Informationen über die erfaßten Spannungen mittels einer Datenschnittstelle 15 und einem daran angeschlossenen Bus 16 digital an die anderen Meßgeräte 7 übertragen, die dazu mit ihren Datenschnittstellen 9 an dem Bus 16 angeschlossen sind.

Um die Leistungsermittlung mit hoher Genauigkeit zu ermöglichen, müssen Phasenabweichungen zwischen den Spannungswandlern 12 und den Stromwandlern 5 kompensiert und die Erfassungszeit der Netzperiode sehr genau ermittelt werden; die Meßgeräte 7, 13 müssen sehr genau zeitsynchronisiert werden, um Phasenfehler zu vermeiden. Dies wird durch eine sehr schnelle Übertragung der digitalen Spannungsinformationen mit einem Zeitfehler von < 1 µs ermöglicht, wodurch ein Phasenfehler von < 1 min, bezogen auf 50 Hz, erreicht wird. Zur Kompensation der Phasenabweichungen zwischen den Spannungswandlern 12 und den Stromwandlern 5 wird in einem Kalibrierungsvorgang die Phasenabweichung für jedes einzelne Meßgerät 7 ermittelt, wobei der Phasenwinkelfehler in einen Speicher 17 des jeweiligen Meßgerätes 7 eingegeben wird; das Meßgerät 7 kompensiert dann aufgrund des gespeicherten Phasenwinkelfehlers automatisch die Phasenwinkelabweichung. Zur Ermittlung des Phasenwinkelfehlers werden dem Meßgerät 7 rechteckförmige Signale über die Stromwandlereingänge 6 und die Datenübertragungseinrichtung 9, 15, 16 zugeführt, wobei der Phasenwinkelfehler, bezogen auf die digital übertragenen Spannungsinformationen, über die Harmonische bestimmt wird.

## Patentansprüche

1. Meßanordnung mit mindestens einem Meßgerät (7) zur Leistungs- und/oder Leistungsfaktormessung an mindestens einer Meßstelle (4) in einem Wechselspannungsnetz (1),
- wobei an einer Spannungserfassungsstelle (10) des Wechselspannungsnetzes (1) eine Spannungswandlereinrichtung (11) mit jeweils einem Spannungswandler (12) für jede Phase des Wechselspannungsnetzes (1) angeordnet ist,
- wobei ferner an jeder Meßstelle (4) jeweils ein Stromwandler (5) für jede Phase angeordnet und an einem Stromwandlereingang (6) eines der jeweiligen Meßstelle (4) zugeordneten Meßgeräts (7) angeschlossen ist, **dadurch gekennzeichnet,**
- **daß** die Spannungswandlereinrichtung (11) und jedes Meßgerät (7) über eine gemeinsame Datenübertragungseinrichtung (9, 15, 16) miteinander verbunden sind, in der vorgegebene Informationen über die erfaßten Spannungen digital an jedes Meßgerät (7) übertragen werden.

2. Meßanordnung nach Anspruch 1, **dadurch gekennzeichnet, daß** die vorgegebenen Informationen über die erfaßten Spannungen die Spannungswerte und die Periodenzeit umfassen.

3. Meßanordnung nach Anspruch 1 oder 2, **dadurch gekennzeichnet, daß** jedes Meßgerät (7) einen Speicher (17) zur Eingabe und Speicherung eines Phasenwinkelfehlers enthält.

4. Meßanordnung nach einem der vorangehenden Ansprüche, **dadurch gekennzeichnet, daß** an der Spannungserfassungsstelle (10) als Spannungswandlereinrichtung (11) ein weiteres Meßgerät (13) mit Spannungswandlereingängen (14) angeordnet ist, an denen die Spannungswandler (12) angeschlossen sind, und daß das weitere Meßgerät (13) zur Erzeugung der vorgegebenen Informationen über die erfaßten Spannungen ausgebildet ist.

## Claims

1. Measuring system with at least one measuring instrument (7) for measuring the power and/or power factor at at least one measuring point (4) in an alternating-voltage network (1),
- a voltage transformer device (11), with a respective voltage transformer (12) for each phase of the alternating-voltage network (1), being disposed at a voltage detection point (10) of the alternating-voltage network (1),
- in addition, a respective current transformer (5) for each phase being disposed at each measuring point (4) and connected to a current transformer input (6) of a measuring instrument (7) assigned to the respective measuring point (4), **characterized in that**
- the voltage transformer device (11) and each measuring instrument (7) are interconnected via a common data transmission device (9, 15, 16) in which predefined information on the detected voltages is digitally transmitted to each measuring instrument (7).

2. Measuring system according to Claim 1, **characterized in that** the predefined information on the detected voltages comprises the voltage values and the period time.

3. Measuring system according to either of Claims 1 or 2, **characterized in that** each measuring instrument (7) comprises a memory (17) for the entry and storage of a phase angle error.

4. Measuring system according to one of the preceding Claims, **characterized in that** there is disposed at the voltage detection point (10), as a voltage transformer device (11), a further measuring instrument (13) with voltage transformer inputs (14) to which the voltage transformers (12) are connected, and the further measuring instrument (13) is designed to generate the predefined information on the detected voltages.

## Revendications

1. Dispositif de mesure comportant au moins un appareil de mesure (7) pour la mesure de puissance et/ou de facteur de puissance en au moins un point de mesure (4) dans un réseau de tension alternative (1),
- dans lequel il y a en un point de détection de tension (10) du réseau de tension alternative (1) un dispositif transformateur de tension (11) avec respectivement un transformateur de tension (12) pour chaque phase du réseau de tension alternative (1),
- dans lequel il y a en plus en chaque point de mesure (4) respectivement un transformateur de courant (5) pour chaque phase, lequel transformateur de courant est raccordé à une entrée de transformateur de courant (6) d'un appareil de mesure (7) associé au point de mesure respectif (4), **caractérisé par le fait**
- **que** le dispositif transformateur de tension (11) et chaque appareil de mesure (7) sont reliés ensemble par l'intermédiaire d'un dispositif de transmission de données (9, 15, 16) commun dans lequel des informations prédéterminées sur les tensions détectées sont transmises de façon numérique à chaque appareil de mesure (7).

2. Dispositif de mesure selon la revendication 1, **caractérisé par le fait que** les informations prédéterminées sur les tensions détectées comprennent les valeurs de tension et la période.

3. Dispositif de mesure selon la revendication 1 ou 2, **caractérisé par le fait que** chaque appareil de mesure (7) contient une mémoire (17) pour l'entrée et la mémorisation d'une erreur d'angle de phase.

4. Dispositif de mesure selon l'une des revendications précédentes, **caractérisé par le fait qu'**il y a au point de détection de tension (10) comme dispositif transformateur de tension (11) un autre appareil de mesure (13) avec des entrées de transformateurs de tension (14) auxquelles les transformateurs de tension (12) sont raccordés et que l'autre appareil de mesure (13) est conçu pour la production des informations prédéterminées sur les tensions détectées.
